# EUROPEAN PATENT APPLICATION

(11) **EP 2 693 622 A1**
(43) Date of publication of application: **05.02.2014**
(21) Application number: 12179010.9
(22) Date of filing: 02.08.2012
(51) Int. Cl.: H02M 7/00, H02J 5/00

(54) **Modular power electronics device**

(71) Applicant: ABB Technology AG, 8050 Zürich (CH)
(72) Inventor: Baumann, David, 5502 Hunzenschwil (CH); Cottet, Didier, 8050 Zürich (CH); Cimino, Mikael, 5507 Mellingen (CH); Steiner, Reto, 4600 Olten (CH); Stevanovic, Ivica, 8953 Dietikon (CH)
(74) Representative: ABB Patent Attorneys

(57) **Abstract**

A power electronics device 10 comprises at least one power module 16 comprising power semiconductors 20, a controller 22 for controlling the power semiconductors 20, and an auxiliary power supply 22 for powering the controller 22; and a rack 14 for supporting the power module 16. The power module 16 comprises a first inductor 40 attached to the power module 16 and electrically connected to the auxiliary power supply 22. The power electronics device 10 comprises a second inductor 42 attached to the rack 14, such that the second inductor 42 is galvanically separated from the first inductor 40. In an installation position of the power module 16 in the rack 14, the first inductor 40 and the second inductor 42 are inductively coupled, such that electrical power is transferable from the second inductor 42 to the first inductor 40. The power module 16 is removable from the installation position, such that the inductive coupling between the first inductor 40 and the second inductor 42 is interrupted.

## Description

### FIELD OF THE INVENTION

The invention relates to a power electronics device and a method of maintaining a power electronics device.

### BACKGROUND OF THE INVENTION

Many power electronics devices are designed in a modular way and comprise power modules that may easily be exchanged, when they have to be maintained. An example for such a power electronics devices is a modular medium voltage power electronics converter that has power modules housing the semiconductor switches of the converter cells.

Each power module usually has a so-called auxiliary power system or auxiliary power supply to provide communication, power switches driving and all related work, while being easily removable/interchangeable and providing the required insulation.

For example, the auxiliary power supply may be connected to local capacitors of the power module and the power module may be directly powered through the local capacitor voltage of the main power circuit. However, in this case, power may be only available during converter operation. During the converter start-up phase, an exact powering sequence may have to be followed.

When the auxiliary power supply is electrically connected to an external power source, the power module usually has to be galvanically isolated from the external power source. A gate unit power supply may be used as auxiliary power supply to provide power and insulation to a power module. A gate unit power supply may comprise one or more solid core transformers molded into insulating polymers. For each power module a power cable needs to be connected by hand, when the power module has to be exchanged or removed. In this case, for example, the power electronics device has to be switched off, the power module has to be earthed, and the supply cables have to be disconnected.

### DESCRIPTION OF THE INVENTION

It is an object of the invention to facilitate the maintenance of a modular power electronics device.

This objective is achieved by the subject-matter of the independent claims. Further exemplary embodiments are evident from the dependent claims and the following description.

A first aspect of the invention relates to a power electronics device. The power electronics device may be a modular converter, for example a modular multi-level converter.

According to an embodiment of the invention, the power electronics device comprises at least one power module comprising power semiconductors, a controller for controlling the power semiconductors, and an auxiliary power supply for powering the controller and a rack, cabinet and/or frame for supporting the power module. It has to be understood that the power electronics device may comprise a plurality of removable power modules.

The power module comprises a first inductor attached to the power module and electrically connected to the auxiliary supply, and a second inductor attached to the rack, such that the second inductor is galvanically separated from the first inductor. The two inductors, which may be coils, may be spatially separated from each other to galvanically isolate the power module from its externalpower supply.

In an installation position of the power module in the rack, the first inductor, and the second inductor are inductively coupled, such that electrical power is transferable from the second inductor to the first inductor. The power module is removable from the installation position, such that the inductive coupling between the first inductor and the second inductor is interrupted. In such a way, when removing the power module from its installation position, the auxiliary power supply is automatically disconnected from an external power supply.

Summarized, a modular power electronics device may comprise power modules mounted in a rack, where the auxiliary power of each module is provided through inductive power transfer between two inductors. The two coupled inductors may be seen as a transformer of an inductive power transfer system, which comprises spatially separable primary and secondary inductors or coils. Since the power transfer is done contactless, this allows easier plugability of the power module (which also may be important also for hot swapping of power modules) and also provides robustness in terms of interchangeability.

The power electronics device may have a modular wireless auxiliary power system that respects high insulation requirements and that links two parts with high differential potential. The power electronics device may have power modules that need to be and that may be easily exchanged. The high insulation auxiliary power system is easy to connect and disconnect. The power modules may easily be plugged into the power electronics device.

According to an embodiment of the invention, in the installation position, the first inductor and the second inductor are galvanically separated via an air gap. For example, the two inductors may be separated about 5 cm or more to prevent sparks between the power module and the rack.

According to an embodiment of the invention, the power module is slideable in a slot in the rack. For example, the rack may have a rail arrangement onto which the power module may slide in the slot. The first inductor may be attached to the back of the power module, and the second inductor may be arranged at the back of the slot. In this configuration, the two inductors come into inductive proximity or contact, when the power module is slid into its installation position.

According to an embodiment of the invention, one of the first and second inductors is an inner coil, and the other one of the first and second inductors is an outer coil surrounding the inner coil, when the power module is in the installation position. The coil arrangement may comprise of concentric coils, which may result in a ring-like air gap between the coils that provides electrical insulations. This arrangement of coils may only need little space in the interior of the power electronics device.

For example, the outer coil may have a ring-like shape surrounding the inner coil. The outer coil may be arranged in a plane substantially orthogonal to the movement direction of the power module in the rack.

According to an embodiment of the invention, the first and/or second coil may have an insulating coating. This may enhance the isolation of the two coils.

According to an embodiment of the invention, the second inductor is the outer coil and the first inductor is the inner coil, i.e. the outer coil may be attached to the power module or to the rack, and the inner coil may be attached to the other one of power module and rack.

According to an embodiment of the invention, the first inductor is a first coil with a ring-like shape, and the second inductor is a second coil with a ring like-shape. The first coil and the second coil may be arranged in two parallel planes. The two coils may be provided in a vis-à-vis like arrangement, with an air gap between the coils that provide electrical insulations.

According to an embodiment of the invention, the first coil and the second coil have the same shape. For example, the windings of the two coils may be arranged along a rectangle.

According to an embodiment of the invention, at least one of the first and second inductors comprises a coil wound around a ferromagnetic core. For example, the inner coil is wound around a magnetic core. This may enhance the efficiency of the inductive coupling.

Also, if two coils are arranged vis-a-vis, the magnetic core, which may extend in the movement direction of the power module, may extend through both coils.

According to an embodiment of the invention, at least one of the first and second inductors comprises a coil partly or fully surrounded by a ferromagnetic ring, for example a ferrite ring. For example, the outer coil is partly or fully surrounded by a ferrite ring. This may reduce the magnetic stray field and may concentrate the magnetic field within the coil.

According to an embodiment of the invention, at least one of the first and second inductors comprises a coil with coil windings made of Litz wires, and/or at least one of the first and second inductors comprises a coil with coil windings that are tracks on a printed circuit boards. These are several (not exhaustive) possibilities of providing easy to manufacture coils.

According to an embodiment of the invention, the power electronics device comprises further a DC-to-AC converter for converting a DC current into an AC current supplied to the second inductor, and an AC-to-DC converter for converting an AC current from the first inductor into a DC current supplied to the auxiliary power supply. The DC-to-DC converter formed of the two converters and the transformer with the two inductors may be used for reducing the DC voltage from the external power supply in the rack into a lower DC voltage for the power module. In such a way, the insulationof the power module and the transformation of the supply voltage of the auxiliary power supply may be performed with the same components.

According to an embodiment of the invention, the power electronics device comprises further an AC-to-DC converter for converting an AC current into a DC current. For example, the external power source may be a main grid. The external low voltage AC power source (e.g. 230 V / 50 Hz) may be converted to a low DC voltage (e.g. 48 V) for distribution in the rack to the sending second inductor of the inductive power transfer system.

According to an embodiment of the invention, the first inductor is electrically coupled to a first capacitor and/or the second inductor is electrically coupled to a second capacitor, such that power is transferred via a resonant circuit. In the power module, in the rack, or in both the power module and the rack, a resonant circuit may be provided by coupling the inductors with a capacitor. This may generate a so-called inductively coupled power transfer. In such a way, the efficiency of the power transfer may be enhanced.

However, it is also possible that the power transfer is performed with a non-resonant coupling.

According to an embodiment of the invention, the power electronics device is a power converter. For example, the power modules may comprise power cells for switching currents.

A further aspect of the invention relates to a method of maintaining a power electronics device. It has to be understood that features of the method as described in the above and in the following may be features of the power electronics device as described in the above and in the following and vice versa.

According to an embodiment of the invention, the method comprises the steps of: moving a power module of the power electronics device into a rack of the power electronics device, such that a first inductor attached to the power module is inductively coupled to a second inductor attached to the rack and such that the first inductor is galvanically separated from the second inductor; powering the second inductor with an electrical current, such that electrical power is transferred from the second inductor to the first inductor and is supplied from the first inductor to an auxiliary power supply of the power electronics module; and removing the power module from the rack, such that the first inductor is spatially separated from the second inductor and the power transfer from the second inductor to the first inductor is interrupted.

Summarized, the connection and disconnection of the auxiliary power supply to an external power supply may be performed while moving the power module into the rack and while removing the power module from the rack. Further additional hand moves are not necessary.

These and other aspects of the invention will be apparent from and elucidated with reference to the embodiments described hereinafter.

### BRIEF DESCRIPTION OF THE DRAWINGS

The subject-matter of the invention will be explained in more detail in the following description with reference to exemplary embodiments which are illustrated in the attached drawings.
Fig. 1 schematically shows a power electronics device according to an embodiment of the invention.
Fig. 2 shows a coil arrangement according to an embodiment of the invention.
Fig. 3 shows a three-dimensional view of a power electronics device according to a further embodiment of the invention.
Fig. 4 shows a three-dimensional view of a coil arrangement according to a further embodiment of the invention.
Fig. 5 shows a three-dimensional view of a coil arrangement according to a further embodiment of the invention.

In principle, identical parts are provided with the same reference symbols in the figures.

### DETAILED DESCRIPTION OF EXEMPLARY EMBODIMENTS

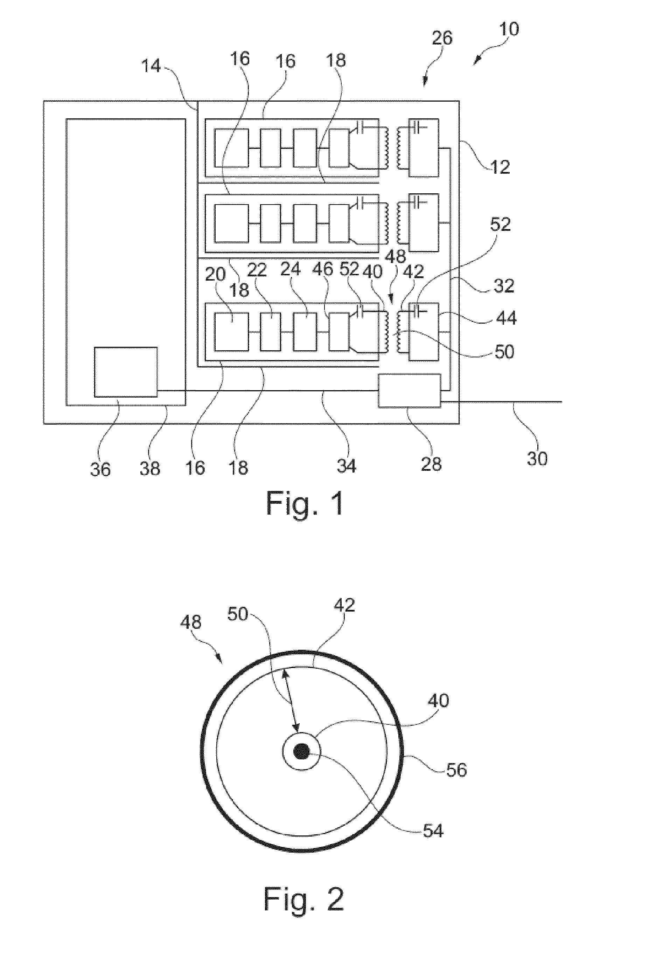

Fig.1 schematically shows a modular power electronics device 10, for example a modular multi-level converter, that comprises a cabinet 12, a rack 14 in the cabinet 12, and a plurality of power modules 16 supported by the rack 14.

Each power module 16 is removable from the rack 14. For example, the rack 14 has rails 18 on which the power modules 16 may slide.

Each power module 16 comprises power semiconductors 20, a controller 22 for controlling the power semiconductors 20, and an auxiliary power supply 24.

The power electronics device comprises a modular auxiliary power system 26 with an AC-to-DC converter 28 that is connected to an electrical grid 30 (for example with 50 Hz, 230 V). The AC-to-DC converter 28 provides a DC voltage 32 (for example 48 V) to be supplied in the direction of the power modules 16. The low AC voltage 34 from the grid 30 may be distributed to further components of the power electronics device, for example to a main controller 36 or to further racks 38.

The modular auxiliary power system 26 is based on wireless, inductive power transfer via a first inductor 40 attached to a power module and a second inductor 42 attached to the rack 14 and placed in the cabinet 12. The low DC voltage 32 is supplied to a DC-to-AC converter 44, which transforms the DC voltage 32 to an AC voltage, which is supplied to the second inductor 42. The electrical power is transferred from the inductor 42 to the inductor 40, which is connected to an AC-to-DC converter 46, which transforms the AC voltage into a DC voltage to be supplied to the auxiliary power supply 24.

For example, the inductor 42 is an emitting coil and the inductor 40 is a receiving coil that forms an arrangement 48 or pair 48 for inductively transferring power to the power module 16. It has to be understood that some or all of the power modules 16 may be associated with more than one pair of coils 40, 42.

Furthermore, the arrangement 48, which may be seen as a transformer formed of the two inductors 40, 42, may be tuned, such that the DC voltage 32 is converted into a lower DC voltage (for example 26 V) after the AC-to-DC converter 46.

A galvanic insulation between the power modules 16 and the rack 14, in particular the other parts of the power electronics device 10, is provided by an air gap 50 between the two inductors 40, 42 that are spatially separated. Further materials, like dielectrics may be additionally provided between the two inductors 40, 42.

The inductive power transfer can be done with a resonance approach, for example in the case of a large air gap 50 and/or if high efficiency is needed. In this case, for forming resonant circuits, the inductors 40, 42 may be coupled with a capacitor 52. However, the inductive power transfer can also be done without resonance, for example in the case of a small air gap 50 and/or where efficiency is less a matter of concern.

The power modules 16 are shown in an installation position, in which the two inductors 40, 42 are arranged in such a way that they are inductively coupled with each other.

The inductor 42 is fixed to the rack 14 and to the cabinet 12, while the inductor 40 is fixed to the power module 16. When a power module 16 is removed from its installation position, the two inductors lose their coupling and the power transfer to the auxiliary power supply 24 is stopped.

Fig. 2 shows an embodiment of a coil arrangement 48, which comprises an inner coil 40 and an outer coil 42. The coils 40, 42 may be concentric with a radial air gap 50 between the two coils 40, 42.

The inner coil 40 surrounds a magnetic core 54, for example an inner ferrite cylinder. The outer coil 42 is surrounded by a ferrite ring 56. The ferrite ring 56 may be a single ring or may be composed of a plurality of segments, which, for example are separated by gaps.

It has to be understood that the inner coil 40 may be attached to the power module 16 or to the rack 14, and the outer coil 42 vice versa.

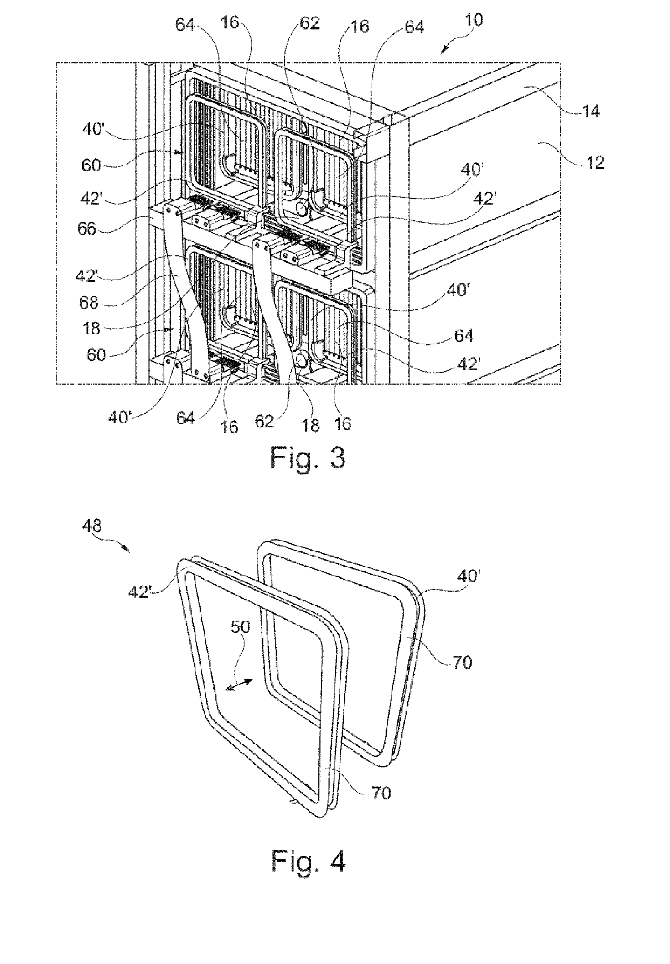

Fig. 3 shows a three-dimensional view of a power electronics device 10 with power modules 16 arranged in slots 60. The power modules 16 have skids 62 that may slide on rails 18. Fig. 3 shows that the inductor 40' is attached to the back 64 of the power module 16 behind a radiator, and that the inductor 42' is attached to the back of the slot 60. The inductor 42' is fixed to a support 66 for supporting power bars 68 of the power electronics device 10. No mechanical connection is needed for power transfer, which intrinsically reinforces the robustness of the interconnection and allows an easy exchange of power modules 16.

The two inductors 40', 42' are arranged in two parallel planes and are spaced apart in a direction in which the power module 16 can be removed from the slot 60.

Fig. 4 shows an arrangement 48 of two inductors 40', 42' of Fig. 3 more detailed. The two inductors 40', 42' comprise windings that are wound around a frame 70 with a U-shaped profile and a rectangular shape. The windings may be made of Litz wire and/or may have an insulating coating.

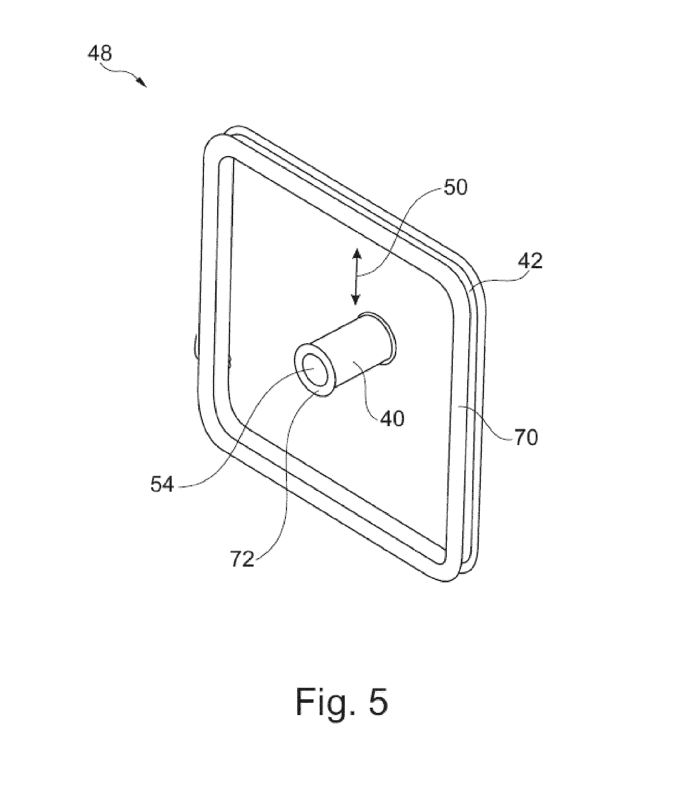

Fig. 5 shows an arrangement 48 of two inductors 40, 42, wherein the inductor 42 is similar to the inductor 42' of Fig. 4. The other inductor 40, similar to Fig. 2, is arranged inside the inductor 42. The inductor 40 comprises windings that are wound around a frame 72 with a U-shaped profile and a circular shape.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

## Claims

1. A power electronics device (10), comprising:
at least one power module (16) comprising power semiconductors (20), a controller (22) for controlling the power semiconductors (20), and an auxiliary power supply (22) for powering the controller (22); and
a rack (14) for supporting the power module (16);
wherein the power module (16) comprises a first inductor (40) attached to the power module (16) and electrically connected to the auxiliary power supply (22);
wherein the power electronics device (10) comprises a second inductor (42) attached to the rack (14), such that the second inductor (42) is galvanically separated from the first inductor (40);
wherein, in an installation position of the power module (16) in the rack (14), the first inductor (40) and the second inductor (42) are inductively coupled, such that electrical power is transferable from the second inductor (42) to the first inductor (40);
wherein the power module (16) is removable from the installation position, such that the inductive coupling between the first inductor (40) and the second inductor (42) is interrupted.

2. The power electronics device (10) of claim 1,
wherein, in the installation position, the first inductor (40) and the second inductor (42) are galvanically separated via an air gap (50).

3. The power electronics device (10) of claim 1 or 2,
wherein the power module (16) is slideable in a slot (60) in the rack (14);
wherein the first inductor (40) is attached to the back (64) of the power module (16) and the second inductor (42) is arranged at the back of the slot (60).

4. The power electronics device (10) of one of the preceding claims,
wherein one of the first and second inductors is an inner coil (40) and the other one of the first and second inductors is an outer coil (42) surrounding the inner coil, when the power module (16) is in the installation position.

5. The power electronics device (10) of claim 4,
wherein the second inductor is the outer coil (42) and the first inductor is the inner coil (40).

6. The power electronics device (10) of one of the preceding claims,
wherein the first inductor (40') is a first coil with a ring-like shape and the second inductor (42') is a second coil with a ring like-shape;
wherein the first coil (40') and the second coil (42') are arranged in two parallel planes.

7. The power electronics device (10) of claim 6,
wherein the first coil (40') and the second coil (42') have the same shape.

8. The power electronics device (10) of one of the preceding claims,
wherein at least one of the first and second inductors (40) comprises a coil wound around a ferromagnetic core (54).

9. The power electronics device of one of the preceding claims,
wherein at least one of the first and second inductors (42) comprises a coil partly or fully surrounded by a ferromagnetic ring (56).

10. The power electronics device (10) of one of the preceding claims,
wherein at least one of the first and second inductors (40, 42, 40', 42') comprises a coil with coil windings made of Litz wires.

11. The power electronics device of one of the preceding claims,
wherein at least one of the first and second inductors comprises a coil with coil windings that are tracks on a printed circuit boards.

12. The power electronics device (10) of one of the preceding claims, further comprising:
a DC-to-AC converter (44) for converting a DC current into an AC current supplied to the second inductor (42);
an AC-to-DC converter (46) for converting an AC current from the first inductor (40) into a DC current supplied to the auxiliary power supply (24).

13. The power electronics device (10) of one of the preceding claims, wherein the first inductor (40) is electrically coupled to a first capacitor (52) and/or the second inductor (42) is electrically coupled to a second capacitor (52), such that power is transferred via a resonant circuit.

14. The power electronics device (10) of one of the preceding claims, wherein the power electronics device is a power converter.

15. A method of maintaining a power electronics device (10), the method comprising the steps of:
moving a power module (16) of the power electronics device (10) into a rack (14) of the power electronics device (10), such that a first inductor (40) attached to the power module (16) is inductively coupled to a second inductor (42) attached to the rack (14), and such that the first inductor (40) is galvanically separated from the second inductor (42);
powering the second inductor (42) with an electrical current, such that electrical power is transferred from the second inductor (42) to the first inductor (40) and is supplied from the first inductor (40) to an auxiliary power supply (24) of the power electronics module (1);
removing the power module (16) from the rack (14) , such that the first inductor (40) is spatially separated from the second inductor (42) and the power transfer from the second inductor (42) to the first inductor (40) is interrupted.
